# EUROPÄISCHE PATENTSCHRIFT

(11) **EP 3 317 964 B1**
(45) Veröffentlichungstag und Bekanntmachung des Hinweises auf die Patenterteilung: **08.04.2020**
(21) Anmeldenummer: 16739430.3
(22) Anmeldetag: 30.06.2016
(51) Int. Cl.: H03F 3/193, H01J 37/32, H03F 3/30

(54) **HOCHFREQUENZVERSTÄRKERANORDNUNG**
HIGH-FREQUENCY AMPLIFIER ARRANGEMENT
ENSEMBLE AMPLIFICATEUR HAUTE FRÉQUENCE

(30) Priorität: 30.06.2015 DE 102015212247
(43) Veröffentlichungstag der Anmeldung: 09.05.2018
(73) Patentinhaber: TRUMPF Hüttinger GmbH + Co. KG, 79111 Freiburg im Breisgau (DE)
(72) Erfinder: GREDE, André, 3018 Bern (CH); ALT, Alexander, Cardiff CF143UA (GB); GRUNER, Daniel, 79379 Muellheim (DE); LABANC, Anton, 79238 Ehrenkirchen (DE)
(74) Vertreter: Trumpf Patentabteilung
(86) Internationale Anmeldenummer: PCT/EP2016/065376
(87) Internationale Veröffentlichungsnummer: WO 2017/001594

(56) Entgegenhaltungen:
- DE-A1- 3 240 726
- JP-A- 2013 135 159
- JP-B2- 4 271 457
- US-A- 5 691 557
- US-A1- 2011 241 781
- US-B1- 6 172 383
- FREDERICK H RAAB ED - ANONYMOUS: "Broadband Class-E Power Amplifier for HF and VHF", MICROWAVE SYMPOSIUM DIGEST, 2006. IEEE MTT-S INTERNATIONAL, IEEE, PI, 1. Juni 2006 (2006-06-01), Seiten 902-905, XP031018618, ISBN: 978-0-7803-9541-1

## Beschreibung

Die Erfindung betrifft eine Hochfrequenzverstärkeranordnung, die geeignet ist, Ausgangsleistungen ≥ 1 kW bei Frequenzen ≥ 2 MHz zur Plasmaanregung zu erzeugen.

Solche oder so ähnliche Vorrichtungen sind beispielsweise aus den folgenden Schriften bekannt: US2014/0167858 A1, US2009/0027936 A1, US6,172,383B1, US6,064,249, JP 2013 1351 59, JP 4271 457.

LDMOS Transistoren sind beispielsweise aus der folgenden Schrift bekannt: Freescale Semiconductor, Technical Data, RF Power LDMOS Transistors, Document Number: MRFE6VP61K25H Rev. 4.1, 3/2014.

Es ist bekannt, für die Erzeugung von Leistungen, die geeignet sind, ein Plasma anzuregen, Transistoren, insbesondere LDMOS-Transistoren, einzusetzen. Derartige Transistoren sind häufig für den Betrieb in den Verstärkerklassen AB vorgesehen. Sollen die Transistoren jedoch für andere Verstärkerklassen eingesetzt werden, z. B. Klasse E oder Klasse F, ist es häufig nicht möglich die Transistoren voll auszusteuern ohne die Spezifikationen der Hersteller bezüglich Gatespannung zu überschreiten. Dieses Überschreiten kann jedoch zu Ausfällen und/oder einer geringeren Lebenszeit der Transistoren führen.

Aufgabe der vorliegenden Erfindung ist es daher, eine Hochfrequenzverstärkeranordnung bereit zu stellen, mit der die oben genannten Nachteile vermieden werden können.

Gelöst wird diese Aufgabe erfindungsgemäß durch eine Hochfrequenzverstärkeranordnung, die geeignet ist, Ausgangsleistungen ≥ 1 kW bei Frequenzen ≥ 2 MHz zur Plasmaanregung zu erzeugen, umfassend:
a. zwei LDMOS-Transistoren, die mit ihrem Sourceanschluss jeweils mit einem Masseverbindungspunkt verbunden sind, wobei die LDMOS-Transistoren gleichartig ausgebildet sind und in einer Baugruppe (Package) angeordnet sind,
b. eine Leiterkarte, die flächig an einer metallischen Kühlplatte anliegt und über mehrere Masseverbindungen mit der mit Masse verbindbaren Kühlplatte verbunden ist, wobei die Baugruppe auf oder an der Leiterkarte angeordnet ist,
c. einen Leistungsübertrager, dessen Primärwicklung mit den Drainanschlüssen der LDMOS-Transistoren verbunden ist,
d. einen Signalübertrager, dessen Sekundärwicklung mit einem ersten Ende über ein oder mehrere resistive Elemente mit dem Gateanschluss des einen LDMOS-Transistor verbunden ist und mit einem zweiten Ende über ein oder mehrere resistive Elemente mit dem Gateanschluss des anderen LDMOS-Transistor verbunden ist, wobei jeder Gatenanschluss über zumindest eine spannungsbegrenzende Bauelementanordnung mit Masse verbunden ist.

So sind die LDMOS-Transistoren voll aussteuerbar, ohne dass die zulässige Gatespannung überschritten wird.

Dadurch, dass spannungsbegrenzende Bauelementanordnungen vorgesehen sind, bekommt die negative Spitze eines Ansteuersignals, welches von der Sekundärwicklung des Signalübertragers kommt, Massepotential. Damit wird die negative Spannung auf den Spannungsabfall an der spannungsbegrenzenden Bauelementanordnung begrenzt und die positive Spitzenspannung erhöht. Dies bedeutet, dass weniger Treiberleistung für Treiber, die die LDMOS-Transistoren ansteuern, notwendig ist. Zusätzlich wird der Leitwinkel, d.h. Zeit, die einer oder beide Transistoren während einer Periode des Ansteuersignals leiten, erhöht, ohne die Notwendigkeit, die Spitzenspannung über den zulässigen Wert zu steigern. Mit anderen Worten kann die Zeit, in der ein Transistor angesteuert ist, verlängert werden. Durch den höheren Gleichanteil ist das Eingangssignal relativ gesehen öfter über der Schwellspannung Uth, der Transistor ist somit öfter leitend.

Durch die gute Anbindung der zwei LDMOS-Transistoren an eine Kühlplatte, kann auch eine thermische Belastung der LDMOS-Transistoren reduziert werden, wodurch die Ausfallwahrscheinlichkeit weiter reduziert wird.

Der Masseverbindungspunkt kann zur Wärmeübertragung von den LDMOS-Transistoren zur Kühlplatte ausgelegt sein. Somit wird eine noch bessere Wärmeabfuhr von den LDMOS-Transistoren sichergestellt und die thermische Belastung der LDMOS-Transistoren weiter reduziert.

Zumindest eine spannungsbegrenzende Bauelementanordnung kann zumindest eine Diode aufweisen, deren Kathode gateseitig und deren Anode masseseitig angeordnet ist. Durch diese Maßnahme bekommt die negative Spitze des Ansteuersignals durch die leitende Diode Massenpotential. Damit wird die negative Spannung des Ansteuersignals auf den Spannungsabfall an der Diode begrenzt.

Zumindest eine spannungsbegrenzende Bauelementanordnung kann mehrere in Reihe geschaltete Dioden aufweisen. Durch diese Maßnahme kann einem Nachteil entgegengewirkt werden, der entsteht, wenn der Verstärker in der Sättigung betrieben wird, wobei dann die Gate-Bias-Spannung weiter steigt und infolgedessen auch der Drain-Strom weiter steigt und die Effizienz sinkt. Dabei können mehrere schnelle Dioden in Reihe geschaltet werden. Eine schnelle Diode im Sinne der Erfindung ist dabei eine Diode, deren Rückwärts-Erholzeit unter einem Viertel der Periodendauer ist. Bei einer Ansteuerfrequenz der Transistoren von z.B. 40,68 MHz (also einer Periodendauer von ca. 25 ns) sind das in etwa 6ns. Die Dioden sollten also eine Rückwärts-Erholzeit von 6 ns oder weniger haben. Dies bedeutet, das eine solche Diode nur vernachlässigbar kurz in Sperrichtung leitet respektive in Leitrichtung sperrt.

Die Reihenschaltung von Dioden kann zumindest zwei Dioden unterschiedlichen Typs aufweisen. Beispielsweise kann die Reihenschaltung eine schnelle Diode und eine Z-Diode aufweisen.

Die zumindest eine spannungsbegrenzende Bauelementanordnung kann zumindest eine Diode und einen Widerstand in Reihenschaltung aufweisen. Auch dadurch können die oben genannten Nachteile reduziert werden. Vorzugsweise ist die Hochfrequenzverstärkeranordnung symmetrisch aufgebaut, d.h. den beiden LDMOS-Transistoren sind identische Bauelementanordnungen zugeordnet.

Die Baugruppe ist auf oder an der Leiterkarte angeordnet sein. Dadurch kann die Baugruppe gut über die Leiterkarte gekühlt werden, die mit der Kühlplatte wärmeleitend verbunden ist. Die Baugruppe kann auf einem Substrat angeordnet sein. Die Baugruppe kann in einem Gehäuse angeordnet sein. Das Gehäuse der Baugruppe kann in einer Durchgangsausnehmung in der Leiterkarte angeordnet sein. Die Anschlüsse der Baugruppe können auf der Leiterkarte kontaktiert sein. Die Baugruppe kann zur Kühlung auf einer Kupferplatte montiert sein. Die Kupferplatte kann zur Wärmeübertragung von der Baugruppe zur Kühlplatte, und insbesondere zur Wärmespreizung, dienen. Die Kupferplatte kann in der gleichen Durchgangsausnehmung in der Leiterkarte angeordnet sein, wie die Baugruppe. Die Kupferplatte kann eine größere Fläche aufweisen, als die der Kühlplatte zugewandte Fläche der Baugruppe. Die Durchgangsausnehmung kann stufig ausgestaltet sein, angepasst zu den Flächen der Kupferplatte und der Baugruppe. Das kann die Lebensdauer der Transistoren zusätzlich erhöhen, da sie sich nicht so stark erwärmen. Außerdem können durch eine Anordnung nah an der mit der Erdung verbundenen Kühlplatte Störungen durch höhe Ströme bei Umschaltvorgängen besser unterdrückt werden.

Die Leiterkarte kann eine mehrlagige Leiterkarte, insbesondere eine mehrlagige Leiterkarte mit mindestens einer Innenlage, insbesondere eine mehrlagige Leiterkarte mit mindestens vier Lagen, sein. Eine Außenlage kann komplett mit der Erdung verbunden sein zur direkten Montage und Kontakt mit der ebenfalls mit der Erdung verbundenen Kühlplatte.

Der Leistungsübertrager kann auf der Leiterkarte oder einer eigenen Leiterkarte angeordnet sein und die Primärwicklung kann planar auf der jeweiligen Leiterkarte ausgebildet sein. Dadurch ergibt sich ein besonders kostengünstiger Aufbau der Primärwicklung. Auch eine Kühlung des Leistungsübertragers kann einfach realisiert werden.

Der Gateanschluss kann über einen Widerstand an einen Kondensator angeschlossen sein, der mit Masse verbunden ist. Durch diese Bauteile und eine Arbeitspunktspannungsquelle kann die Gatekapazität entladen werden. Der Widerstand kann dabei einen Widerstandswert kleiner 1 kΩ aufweisen und der Kondensator kann eine Kapazität größer 1 nF aufweisen.

Die Widerstände können an einen gemeinsamen Kondensator angeschlossen sein, der wiederum an die Arbeitspunktspannungsquelle angeschlossen sein kann.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

Es zeigen:
- Fig. 1: eine erste Ausführungsform einer erfindungsgemäßen Hochfrequenzverstärkeranordnung;
- Fig. 2.: eine zweite Ausführungsform einer erfindungsgemäßen Hochfrequenzverstärkeranordnung;
- Fig. 3: zwei unterschiedliche Spannungsverläufe zur Darstellung der Wirkung der Erfindung.

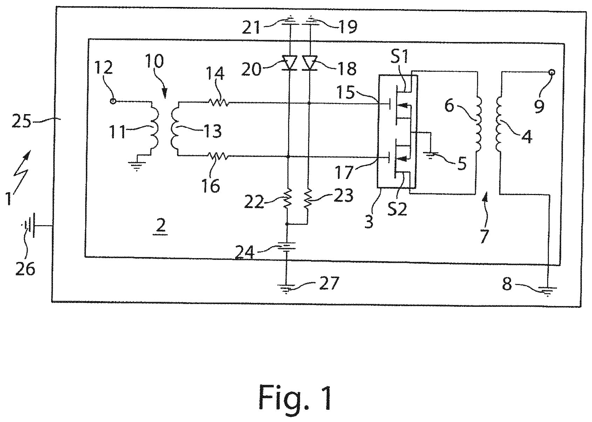

Die Figur 1 zeigt eine erste Ausführungsform einer Hochfrequenzverstärkeranordnung 1. Die Hochfrequenzverstärkeranordnung 1 umfasst eine Leiterkarte 2, auf der eine Baugruppe 3 angeordnet ist. Die Baugruppe 3 weist zwei LDMOS-Transistoren S1, S2 auf, die gleichartig ausgebildet sind und die mit ihrem Sourceanschluss jeweils mit einem Masseverbindungspunkt 5 verbunden sind. Mit ihren Drainanschlüssen sind die LDMOS-Transistoren S1, S2 jeweils mit einem Ende einer Primärwicklung 6 eines Leistungsübertragers 7 verbunden. Die Sekundärwicklung 4 des Leistungsübertragers 7 ist zum einem mit Masse 8 und zum anderen mit einem Hochfrequenzausgang 9 verbunden. Die Hochfrequenzverstärkeranordnung 1 weist weiterhin einen Signalübertrager 10 auf, der eine Primärwicklung 11 aufweist, die an einen Hochfrequenzeingang 12 angeschlossen ist. Die Sekundärwicklung 13 des Signalübertragers 10 ist zum einen über ein resistives Element 14, insbesondere einen Widerstand, mit dem Gateanschluss 15 des LDMOS-Transistors S1 verbunden. Zum anderen ist die Sekundärwicklung 13 über ein resistives Element 16, insbesondere einen Widerstand, mit dem Gateanschluss 17 des LDMOS-Transistors S2 verbunden. Die resistiven Elemente 14, 16 und die Sekundärwicklung 13 sind somit in Reihe geschaltet. Der Signalübertrager 10 ist ebenfalls auf der Leiterkarte 2 angeordnet, genauso wie der Leistungsübertrager 7.

Der Gateanschluss 15 ist über eine spannungsbegrenzende Bauelementanordnung 18, die hier als Diode ausgebildet ist, mit Masse 19 verbunden. Dabei ist die Kathode der Diode gateseitig und die Anode masseseitig angeordnet. Entsprechend ist der Gateanschluss 17 über eine spannungsbegrenzende Bauelementanordnung 20, die hier ebenfalls als Diode ausgebildet ist, ebenfalls mit Masse 21 verbunden. Durch diese Maßnahme können die Ansteuersignale der Gateanschlüsse 15, 17 spannungsverschoben (amplitudenverschoben) werden.

Die Gateanschlüsse 15, 17 sind außerdem über Widerstände 22, 23 mit einer Gleichspannungsquelle 24, d.h. einer Arbeitspunktspannungsquelle, verbunden. Eine Treiberschaltung zur Generierung der Ansteuersignale der LDMOS-Transistoren S1, S2 umfasst im Ausführungsbeispiel der Figur 1 somit den Hochfrequenzeingang 12, den Signalübertrager 10, die resistiven Elemente 14, 16, die spannungsbegrenzenden Bauelementanordnungen 18, 20, die Widerstände 22, 23 und die Gleichspannungsquelle 24.

Die Leiterkarte 2 liegt flächig auf einer Kühlplatte 25 auf, die ebenfalls mit Masse 26 verbindbar ist. Insbesondere ist die Leiterkarte 2 über mehrere Masseverbindungen 8, 19, 21, 27 mit der Kühlplatte 25 verbunden. Die Masseverbindung 5 stellt einen Masseverbindungspunkt zur Wärmeübertragung von den LDMOS-Transistoren S1, S2 zur Kühlplatte 25 dar.

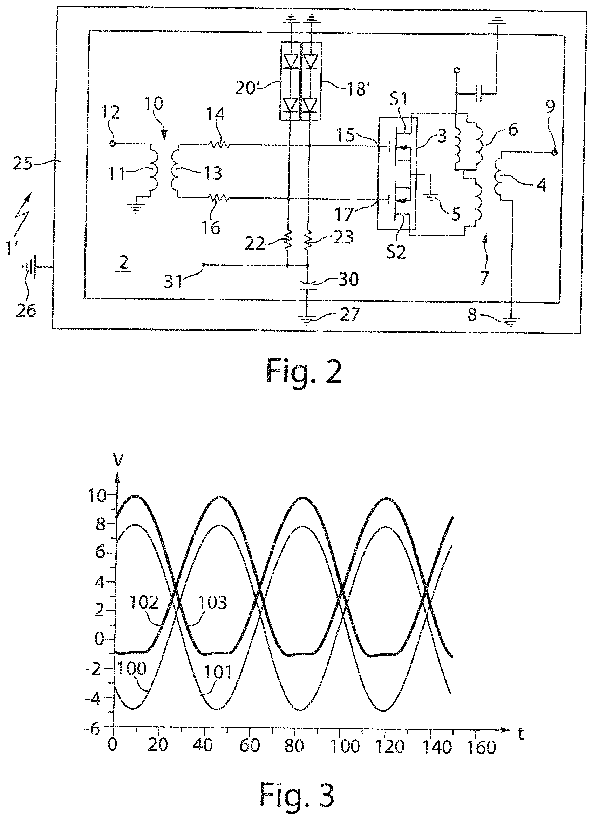

Die Figur 2 zeigt eine alternative Ausgestaltung einer Hochfrequenzverstärkeranordnung 1', wobei die Bauelemente, die mit denen der Figur 1 übereinstimmen, dieselbe Bezugsziffer tragen. Ein Unterschied der Hochfrequenzverstärkeranordnung 1' liegt darin, dass die spannungsbegrenzende Bauelementanordnung 18' in diesem Fall zwei in Serie geschaltete Dioden aufweist. Entsprechend ist die spannungsbegrenzende Bauelementanordnung 20' ausgebildet.

Ein weiterer Unterschied besteht darin, dass die Widerstände 22, 23 mit einem Kondensator 30 verbunden sind, der seinerseits mit Masse 27 verbunden ist. An den Anschluss 31 ist eine Gleichspannungsquelle (Arbeitspunktspannungsquelle) angeschlossen.

Die Figur 3 zeigt mehrere Spannungsverläufe über die Zeit, wie sie an den Gateanschlüssen 15, 17 als Ansteuersignale anliegen wobei der Spannungsverlauf 100 am Gateanschluss 15 anliegt, wenn keine spannungsbegrenzende Bauelementanordnung 18 bzw. 18' vorhanden ist und der Spannungsverlauf 101 entsprechend am Gateanschluss 17 anliegt, wenn keine spannungsbegrenzende Bauelementanordnung 20 bzw. 20' vorgesehen ist. Die Wirkung der spannungsbegrenzenden Bauelementanordnungen 18, 18', 20, 20' ist in den Spannungsverläufen 102, 103 sichtbar, wo die negative Spitze der Spannungsverläufe 102, 103 in etwa auf die Spannung der spannungsbegrenzenden Bauelementanordnungen 18, 18', 20, 20', insbesondere auf die an einer oder mehreren Dioden abfallende Spannung begrenzt ist. Insgesamt ist die Spannung der Spannungsverläufe 102, 103, die an den Gateanschlüssen 15, 17 anliegen, wenn eine spannungsbegrenzende Bauelementanordnung 18, 18', 20, 20' eingesetzt wird, zu höheren Spannungswerten verschoben. Insbesondere wird die positive Spitzenspannung erhöht und die negative Spitze der Ansteuersignale der Gateanschlüsse 15, 17 wird auf den Spannungsabfall, beispielsweise an den Dioden, der spannungsbegrenzenden Bauelementanordnung 18, 18', 20, 20', begrenzt. Dadurch wird eine geringere Treiberleistung, d.h. Leistung des HF-Signals am Hochfrequenzeingang 12, benötigt. Eine kleinere Gate-Spannung führt zu einer Reduktion des Ausfallrisikos der LDMOS-Transistoren S1, S2.

## Patentansprüche

1. Hochfrequenzverstärkeranordnung (1), die geeignet ist, Ausgangsleistungen ≥ 1kW bei Frequenzen ≥ 2MHz zur Plasmaanregung zu erzeugen, umfassend:
a. zwei LDMOS-Transistoren (S1, S2), die mit ihrem Sourceanschluss jeweils mit einem Masseverbindungspunkt (5) verbunden sind, wobei die LDMOS-Transistoren (S1, S2) gleichartig ausgebildet sind und in einer Baugruppe (3) angeordnet sind,
b. eine Leiterkarte (2), die flächig an einer metallischen Kühlplatte (25) anliegt und über mehrere Masseverbindungen (8, 19, 21, 24) mit der mit Masse (26) verbindbaren Kühlplatte (25) verbunden ist, wobei die Baugruppe (3) auf oder an der Leiterkarte angeordnet ist,
c. einen Leistungsübertrager (7), dessen Primärwicklung (6) mit den Drainanschlüssen der LDMOS-Transistoren (S1, S2) verbunden ist,
d. einen Signalübertrager (10), dessen Sekundärwicklung (13) mit einem ersten Ende über ein oder mehrere resistive Elemente (14) mit dem Gateanschluss (15) des einen LDMOS-Transistors (S1) verbunden ist und mit einem zweiten Ende über ein oder mehrere resistive Elemente (16) mit dem Gateanschluss (17) des anderen LDMOS-Transistors (S2) verbunden ist, wobei jeder Gatenanschluss (15, 17) über zumindest eine spannungsbegrenzende Bauelementanordnung (18, 20, 18', 20') mit Masse (19, 21) verbunden ist.

2. Hochfrequenzverstärkeranordnung nach Anspruch 1, **dadurch gekennzeichnet, dass** der Masseverbindungspunkt (5) zur Wärmeübertragung von den LDMOS-Transistoren (S1, S2) zur Kühlplatte (25) ausgelegt ist.

3. Hochfrequenzverstärkeranordnung nach einem der vorhergehenden Ansprüche, **dadurch gekennzeichnet, dass** zumindest eine spannungsbegrenzende Bauelementanordnung (18, 18', 20, 20') zumindest eine Diode aufweist, deren Kathode gateseitig und deren Anode masseseitig angeordnet ist.

4. Hochfrequenzverstärkeranordnung nach einem der vorhergehenden Ansprüche, **dadurch gekennzeichnet, dass** zumindest eine spannungsbegrenzende Bauelementanordnung (18', 20') mehrere in Reihe geschaltete Dioden aufweist.

5. Hochfrequenzverstärkeranordnung nach Anspruch 4, **dadurch gekennzeichnet, dass** die Reihenschaltung von Dioden zumindest zwei Dioden unterschiedlichen Typs aufweist.

6. Hochfrequenzverstärkeranordnung nach einem der vorhergehenden Ansprüche, **dadurch gekennzeichnet, dass** zumindest eine spannungsbegrenzende Bauelementanordnung zumindest eine Diode und einen Widerstand in Reihenschaltung aufweist

7. Hochfrequenzverstärkeranordnung nach einem der vorhergehenden Ansprüche, **dadurch gekennzeichnet, dass** der Leistungsübertrager (7) auf der Leiterkarte (2) oder einer eigenen Leiterkarte angeordnet ist und die Primärwicklung (6) planar auf der jeweiligen Leiterkarte (2) ausgebildet ist.

8. Hochfrequenzverstärkeranordnung nach einem der vorhergehenden Ansprüche, **dadurch gekennzeichnet, dass** jeder Gateanschluss (15, 17) über einen Widerstand (22,23) an einen Kondensator (30) angeschlossen ist, der mit Masse verbunden ist.

9. Hochfrequenzverstärkeranordnung nach Anspruch 8, **dadurch gekennzeichnet, dass** die Gateanschlüsse (15, 17) außerdem über Widerstände (22, 23) mit einer Gleichspannungsquelle (24) verbunden sind.

10. Hochfrequenzverstärkeranordnung nach Anspruch 8 oder 9, **dadurch gekennzeichnet, dass** die Widerstände (22, 23) an einen gemeinsamen Kondensator (30) angeschlossen sind.

11. Hochfrequenzverstärkeranordnung nach Anspruch 10, **dadurch gekennzeichnet, dass** der gemeinsame Kondensator (30) an die Gleichspannungsquelle (24) angeschlossen ist, durch die die Gatekapazität entladen werden kann.

12. Hochfrequenzverstärkeranordnung nach Anspruch 8, **dadurch gekennzeichnet, dass** der Widerstand (22, 23) einen Widerstandswert kleiner 1 kΩ aufweist und der Kondensator (30) eine Kapazität größer 1 nF aufweist.

13. Hochfrequenzverstärkeranordnung nach einem der vorhergehenden Ansprüche 4 bis 12, **dadurch gekennzeichnet, dass** die in Reihe geschalteten Dioden eine Rückwärts-Erholzeit unter einem Viertel der Periodendauer der Ansteuerfrequenz der LDMOS-Transistoren (S1, S2) aufweisen.

14. Hochfrequenzverstärkeranordnung nach einem der vorhergehenden Ansprüche, **dadurch gekennzeichnet, dass** die Hochfrequenzverstärkeranordnung symmetrisch aufgebaut ist, wobei den beiden LDMOS-Transistoren (S1, S2) identische Bauelementanordnungen zugeordnet sind.

15. Hochfrequenzverstärkeranordnung nach einem der vorhergehenden Ansprüche, **dadurch gekennzeichnet, dass** die Baugruppe (3) auf oder an der Leiterkarte (2) angeordnet ist, so dass die Baugruppe (3) über die Leiterkarte (2) gekühlt wird, die mit der Kühlplatte (25) wärmeleitend verbunden ist.

## Claims

1. High-frequency amplifier arrangement (1) that is suitable for generating output power of ≥ 1 kW at frequencies of ≥ 2 MHz for plasma excitation, comprising:
a. two LDMOS transistors (S1, S2), which are each connected to an earth connection point (5) by their respective source terminals, wherein the LDMOS transistors (S1, S2) are embodied alike and are arranged in a package (3),
b. a circuit board (2), which lies flat on a metal cooling plate (25) and is connected to the cooling plate (25), which can be connected to earth (26), by a plurality of earth connections (8, 19, 21, 24), wherein the package (3) is arranged at or on the circuit board,
c. a power transformer (7), the primary winding (6) of which is connected to the drain terminals of the LDMOS transistors (S1, S2),
d. a signal transformer (10), the secondary winding (13) of which is connected at a first end to the gate terminal (15) of one LDMOS transistor (S1) by one or more resistive elements (14), and is connected at a second end to the gate terminal (17) of the other LDMOS transistor (S2) by one or more resistive elements (16), wherein each gate terminal (15, 17) is connected to earth (19, 21) by at least one voltage-limiting component arrangement (18, 20, 18', 20').

2. High-frequency amplifier arrangement according to claim 1, **characterized in that** the earth connection point (5) is configured to transfer heat from the LDMOS transistors (S1, S2) to the cooling plate (25).

3. High-frequency amplifier arrangement according to any one of the preceding claims, **characterized in that** at least one voltage-limiting component arrangement (18, 18', 20, 20') comprises at least one diode, the cathode of which is arranged on the gate side and the anode of which is arranged on the earth side.

4. High-frequency amplifier arrangement according to any one of the preceding claims, **characterized in that** at least one voltage-limiting component arrangement (18', 20') comprises a plurality of diodes connected in series.

5. High-frequency amplifier arrangement according to claim 4, **characterized in that** the series connection of diodes comprises at least two diodes of different types.

6. High-frequency amplifier arrangement according to any one of the preceding claims, **characterized in that** at least one voltage-limiting component arrangement comprises at least one diode and one resistor connected in series.

7. High-frequency amplifier arrangement according to any one of the preceding claims, **characterized in that** the power transformer (7) is arranged on the circuit board (2) or on a separate circuit board, and the primary winding (6) is formed in a planar manner on the relevant circuit board (2).

8. High-frequency amplifier arrangement according to any one of the preceding claims, **characterized in that** each gate terminal (15, 17) is connected, by means of a resistor (22, 23), to a capacitor (30) connected to earth.

9. High-frequency amplifier arrangement according to claim 8, **characterized in that** the gate terminals (15, 17) are additionally connected, by means of resistors (22, 23), to a DC voltage source (24).

10. High-frequency amplifier arrangement according to either claim 8 or claim 9, **characterized in that** the resistors (22, 23) are connected to a common capacitor (30).

11. High-frequency amplifier arrangement according to claim 10, **characterized in that** the common capacitor (30) is connected to the DC voltage source (24), through which the gate capacitance can be discharged.

12. High-frequency amplifier arrangement according to claim 8, **characterized in that** the resistor (22, 23) has a resistance value of less than 1 kΩ and the capacitor (30) has a capacitance of more than 1 nF.

13. High-frequency amplifier arrangement according to any one of the preceding claims, claims 4 to 12, **characterized in that** the diodes connected in series have a reverse recovery time that is less than a quarter of the cycle duration of the driving frequency of the LDMOS transistors (S1, S2).

14. High-frequency amplifier arrangement according to any one of the preceding claims, **characterized in that** the high-frequency amplifier arrangement is symmetrical, the two LDMOS transistors (S1, S2) having identical component arrangements.

15. High-frequency amplifier arrangement according to any one of the preceding claims, **characterized in that** the package (3) is arranged at or on the circuit board (2) such that the package (3) is cooled via the circuit board (2), which is connected to the cooling plate (25) in a heat-conducting manner.

## Revendications

1. Ensemble amplificateur haute fréquence (1), lequel est adapté à la génération des puissances de sortie ≥ 1 kW à des fréquences ≥ 2 MHz pour une excitation d'un plasma, comprenant :
a. deux transistors LDMOS (S1, S2), chaque transistor respectif étant raccordé, à l'aide de sa borne de source, à un point de connexion à la terre (5), dans lequel les transistors LDMOS (S1, S2) sont réalisés de manière similaire et disposés dans un module (3),
b. une carte de circuit imprimé (2), laquelle repose à plat sur une plaque de refroidissement (25) métallique et laquelle est reliée, par l'intermédiaire d'une pluralité de prises de terre (8, 19, 21, 24), à la plaque de refroidissement (25) pouvant être reliée à la terre (26), dans lequel le module (3) est disposé sur ou contre la carte de circuit imprimé,
c. un dispositif de transmission de puissance (7), dont l'enroulement primaire (6) est relié aux bornes de drain des transistors LDMOS (S1, S2),
d. un dispositif de transmission de signaux (10), dont l'enroulement secondaire (13), à l'aide d'une première extrémité, est relié, par l'intermédiaire d'au moins un élément (14) résistif, à une borne de grille (15) de l'un des transistors LDMOS (S1) et, à l'aide d'une seconde extrémité, par l'intermédiaire d'au moins un élément (16) résistif, à la borne de grille (17) de l'autre transistor LDMOS (S2), dans lequel la borne de grille (15, 17) respective est reliée, par l'intermédiaire d'au moins un agencement de composants (18, 20, 18', 20') limiteurs de tension, à la terre (19, 21).

2. Ensemble amplificateur haute fréquence selon la revendication 1, **caractérisé en ce que** le point de connexion à la terre (5) est conçu pour transférer la chaleur des transistors LDMOS (S1, S2) vers la plaque de refroidissement (25).

3. Ensemble amplificateur haute fréquence selon l'une quelconque des revendications précédentes, **caractérisé en ce qu'**au moins un agencement de composants (18, 18', 20, 20') limiteurs de tension comporte au moins une diode, dont la cathode est disposée côté grille et l'anode côté terre.

4. Ensemble amplificateur haute fréquence selon l'une quelconque des revendications précédentes, **caractérisé en ce qu'**au moins un agencement de composants (18', 20') limiteurs de tension comporte une pluralité de diodes montées en série.

5. Ensemble amplificateur haute fréquence selon la revendication 4, **caractérisé en ce que** le montage en série des diodes comporte au moins deux diodes de types différents.

6. Ensemble amplificateur haute fréquence selon l'une quelconque des revendications précédentes, **caractérisé en ce qu'**au moins un agencement de composants limiteurs de tension comporte au moins une diode et une résistance montées en série.

7. Ensemble amplificateur haute fréquence selon l'une quelconque des revendications précédentes, **caractérisé en ce que** le dispositif de transmission de puissance (7) est disposé sur la carte de circuit imprimé (2) ou sur sa propre carte de circuit imprimé et l'enroulement primaire (6) se présente sous la forme planaire sur la carte de circuit imprimé (2) respective.

8. Ensemble amplificateur haute fréquence selon l'une quelconque des revendications précédentes, **caractérisé en ce que** la borne de grille (15, 17) respective est reliée par l'intermédiaire d'une résistance (22, 23) à un condensateur (30), lequel est relié à la terre.

9. Ensemble amplificateur haute fréquence selon la revendication 8, **caractérisé en ce que** les bornes de grille (15, 17) sont en outre reliées à une source de tension continue (24) par l'intermédiaire des résistances (22, 23).

10. Ensemble amplificateur haute fréquence selon la revendication 8 ou 9, **caractérisé en ce que** les résistances (22, 23) sont reliées à un condensateur (30) commun.

11. Ensemble amplificateur haute fréquence selon la revendication 10, **caractérisé en ce que** le condensateur (30) commun est relié à la source de tension continue (24) à travers laquelle la capacité de grille peut être déchargée.

12. Ensemble amplificateur haute fréquence selon la revendication 8, **caractérisé en ce que** la résistance (22, 23) présente une valeur de résistance inférieure à 1 kΩ et le condensateur (30) présente une capacité supérieure à 1 nF.

13. Ensemble amplificateur haute fréquence selon l'une quelconque des revendications 4 à 12 précédentes, **caractérisé en ce que** les diodes montées en série présentent un temps de rétablissement inverse inférieur à un quart de la durée de période de la fréquence d'attaque des transistors LDMOS (S1, S2).

14. Ensemble amplificateur haute fréquence selon l'une quelconque des revendications précédentes, **caractérisé en ce que** l'ensemble amplificateur haute fréquence est conçu symétriquement, dans lequel des agencements de composants identiques sont affectés aux deux transistors LDMOS (S1, S2).

15. Ensemble amplificateur haute fréquence selon l'une quelconque des revendications précédentes, **caractérisé en ce que** le module (3) est disposé sur ou contre la carte de circuit imprimé (2) de telle sorte que ledit module (3) est refroidi à l'aide de la carte de circuit imprimé (2), laquelle est reliée de manière thermoconductrice à la plaque de refroidissement (25).
